(19) Europäisches Patentamt
European Patent Office
Office européen des brevets

(11) Publication number: 0 006 481 A2

# (12) EUROPEAN PATENT APPLICATION

(21) Application number: 79101718.9

(22) Date of filing: 01.06.79

(51) Int. Cl.³: G 11 C 19/08

(30) Priority: 27.06.78 US 919598

(43) Date of publication of application: 09.01.80 Bulletin 80/1

(84) Designated Contracting States: DE FR GB IT NL SE

(71) Applicant: **International Business Machines Corporation, Armonk, N.Y. 10504 (US)**

(72) Inventor: **Keefe, George Edward, 25 Covert Street, Montrose, NY 10548 (US)**
Inventor: **Pugh, Emerson William, Brandon Drive, Mount Kisco, NY 10549 (US)**

(74) Representative: **de Haas, John, IBM Nederland N.V. Patent Operations Watsonweg 2, NL-1420 AA Uithoorn (NL)**

## (54) Bubble domain storage chip.

(57) In magnetic bubble domain storage systems, it is important that the data exit from the storage in the same sequence in which it entered the storage. In major/minor loop memory organizations using separate read and write major paths, this is easily achieved with gapped propagation elements such as T-bars, C-bars, half disks, and chevrons. However, because contiguous disk propagation elements are gapless, this has not been achieved. To solve this, a data reversal switch is provided which reverses the order of the data before it is entered into the minor loop storage registers. When the data is removed from the minor loops, it will have the same sequence as it had initially, thus avoiding data reversal. The data reversal switch is comprised of two adjacent, oppositely propagating contiguous propagation element patterns in which a parallel transfer of sequentially written data can be made. This reverses the order of the data from what it was initially, so that upon exiting from the storage loops the initial order will again be achieved.

WRITE PATH
REVERSAL PATH
WRITE MAJOR PATH
READ MAJOR PATH
TO SENSOR

EP 0 006 481 A2

International Business Machines Corporation,
Armonk (New York), United States of America.

Bubble domain storage chip.

The invention relates to a magnetic bubble domain storage chip comprised of patterns of contiguous magnetic propagation elements having in-plane magnetization, along which patterns move bubble domains in response to the continuous reorientation of a magnetic field through a plurality of cycles, said magnetic field reorienting in the same sense in each of said cycles, said patterns forming a first shift register for serially moving a first data sequence pattern of magnetic bubble domains, a plurality of storage registers for storing said bubble domains received from said first shift register, and a second shift register for serially moving bubble domains in a data pattern received from said storage registers.

An important systems requirement for magnetic bubble domain storage arrays is that the data must exit from storage in the same sequence in which it entered the storage. In most storage organizations this is easily achieved when gapped propagation elements are used. This is so because data can be transferred to the gapped elements from either side of the element and can travel along the pattern of the elements in a preferred direction in accordance with the sense of rotation of an in-plane drive field. For example, a pattern of T-bars, C-bars, half disks, or chevrons, can be used to move bubble domains in either of two directions depending upon the direction of rotation of the in-plane drive field. Bubble domains can be transferred to the propagation pattern from either side of the pattern and the pattern can be used to move bubble domains in a preferred direction.

In contrast with this, contiguous propagation elements are provided by ion implanting regions in a magnetic layer or by apertured regions in a continuous magnetic layer. As is well known, bubble domains travel along the edges of the ion implanted regions or along the edges of the apertured regions, staying at all times under the magnetic layer having in-plane magnetization. In such structures, it is not easy to move a bubble domain across a non-ion implanted region or across a region in which the in-plane magnetic layer is absent. Thus, when bubble domains are transferred to a propagation pattern comprising contiguous propagation elements, transfer is to the nearest edge of the elements and the bubble domain cannot easily be moved across the propagation elements to the opposite edge. Instead, the bubble domain gets to the opposite edge of the propagation elements only by travelling around the full propagation pattern. If the nearest edge is one which will not propagate the bubbles in a direction to preserve data order, then the aforementioned reversal problem will occur.

As an example, a propagation pattern comprising contiguous disks can be used to move bubble domains in response to the reorientation of a magnetic field in the plane of the propagation elements. A bubble domain which is transferred to this propagation pattern will stay along the edge to which it is transferred and cannot be easily moved across the propagation pattern to the opposite edge. Because of this, a designer using propagation patterns comprising contiguous propagation elements cannot easily regulate the direction of movement of bubble domains along the pattern if bubble domains are transferred to the propagation pattern from a fixed direction. That is, the bubbles can't be transferred to either opposing edge of the contiguous element pattern, but only to the closest edge, which may not provide the direction of movement which preserves data order.

In particular, major/minor loop memory organizations are well known in which separate read and write major paths are provided. For example, U.S. patent 3.999.172 describes such a storage organization, while U.S. patent 3.838.407 describes a storage organization using a single, broken major loop. In such storage organizations, it is desirable from a systems' standpoint to have the order of data leaving the storage registers be the same as that when it enters the storage registers. If this is not done, compensation must be provided in the associated electronic circuits external to the magnetic chip.

In a major/minor loop organization using separate read and write major paths, the major paths are located on opposite sides of the minor loop storage registers. This means that bubble domains are transferred in a fixed direction both from the write major path to the minor loops and from the minor loops to the read major path. Because the bubble domains can enter a propagation path comprised of gapped propagation elements from either side of the elements, data reversal is easily solved using such gapped propagation elements. However, when contiguous propagation elements are used in the write and read major paths, data reversal results because bubble domains cannot easily move across the propagation pattern. The present invention addresses this problem and provides a solution which can be used in memory organizations having contiguous propagation element patterns.

Accordingly, it is a primary object of this invention to provide a structure which eliminates data reversal in magnetic bubble domain storage organizations using contiguous propagation elements.

It is another object of the present invention to provide a structure for eliminating data reversal in a bubble domain major/minor loop memory organization using separate write and read major paths comprised of contiguous propagation elements.

It is another object of the present invention to provide means to eliminate reversal of data order in a magnetic bubble domain storage organization having separate input and output bubble propagation paths, where contiguous propagation elements are used to move bubble domains along the input and output paths.

It is another object of the present invention to provide a structure for preventing data reversal in a bubble domain storage system in which data enters the storage and exits from the storage along two different bubble propagation paths, in a manner which does not cause loss of performance in access time or data rate.

It is another object of the present invention to provide an on-chip solution to the problem of data reversal in bubble domain major/minor loop memory organizations using separate read and write propagation paths comprised of contiguous propagation elements.

In order to achieve the above objectives the bubble domain storage chip of the kind indicated in the preamble is characterized in that said magnetic bubble domain storage chip further comprises reversal means located on said magnetic chip between said first shift register and said storage registers for receiving said data pattern of bubble domains and for changing said first data sequence to a second data sequence, which is the reverse of said first data sequence, said reversal means including a bubble domain propagation path along which bubble domains in said data pattern move in response to the reorientation of said magnetic field, first transfer means for parallel transfer of said domains from said first shift register to said propagation path, and second transfer means for parallel transfer of said domains from said reversal means to said storage registers.

This invention is particularly directed to magnetic bubble domain memory organizations where the order of data entered into storage may be different from the order of data removed from storage. More particularly, this invention is directed to such memory organizations where contiguous propagation elements are used for writing in data and removing data from storage.

The invention provides a loop around which the data is reversed in order, either before it is entered into storage or after it is removed from storage. In a major/minor loop type of bubble organization using separate read and write major paths, one embodiment of the present invention uses a data reversal loop between the bubble domain generator and the minor loop storage registers in order to reverse the order of data from the generator, prior to entry of the data into the minor loop storage registers. When the data is removed from the storage registers, its order is again reversed so that it is now identical to the order it had when it came from the bubble domain generator.

A particular embodiment will be illustrated using a major/minor loop organization having separate read and write major paths, where the read and write major paths as well as the storage minor loops are comprised of contiguous propagation elements, along which bubble propagation occurs in the presence of a magnetic drive field in the plane of the propagation elements, the drive field being a rotating field having a constant sense of rotation.

These and other objects, features, and advantages will be more apparent from the following more particular description of the preferred embodiments.

Fig. 1 illustrates a prior art major/minor loop bubble storage organization using separate write and read major paths, where the order of data is the same in the write and read major paths.

Fig. 2A illustrates an attempt to provide a contiguous element propagation structure for moving data along the propagation paths shown in fig. 1, in which there is no data reversal but in which operability is marginal at best.

Fig. 2B is a major/minor loop bubble storage system, which does not have the problem of the structure of fig. 2A, but in which the order of data is reversed in the write and read major paths.

Fig. 3 illustrates the implementation of a data reversal switch in accordance with the present invention, which eliminates the problem of data reversal of information in the read and write major paths of a bubble domain major/minor loop memory organization.

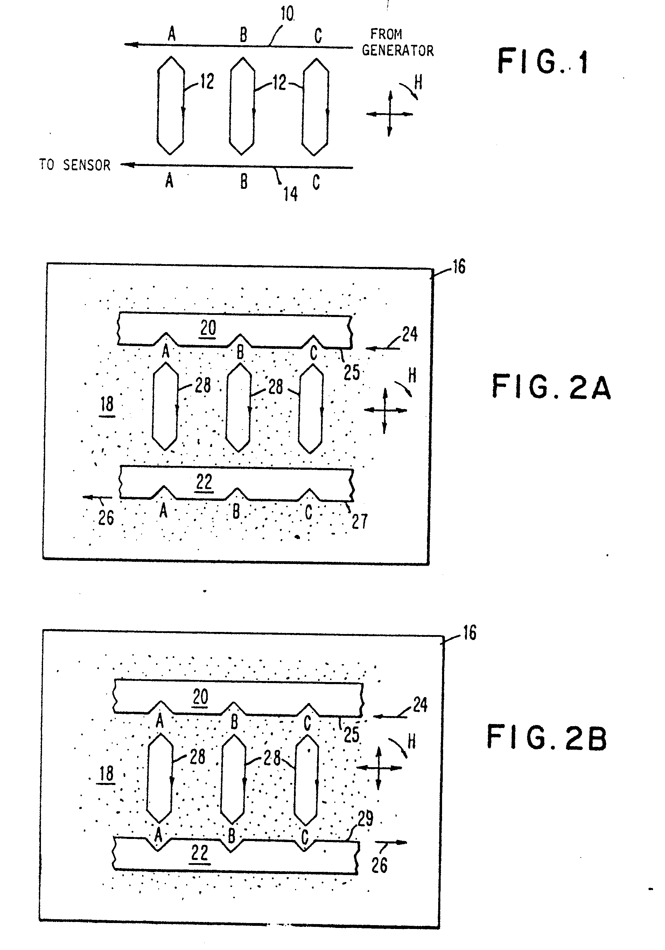

The figures 1, 2A and 2B illustrate the problem of data reversal and show two unsuccessful attempts to implement major/minor loop bubble memory organizations using contiguous propagation elements.

In more detail, fig. 1 illustrates a major/minor loop bubble memory organization using separate write and read major paths. Only the bubble propagation paths are shown in this figure.

A write major path 10 is used to move bubble domains from a generator (not shown) to positions opposite the minor loop storage registers 12. In accordance with well known principles, bubble domains can be transferred from write major path 10 to the minor loop storage registers 12, around which these bubble domains propagate in the direction indicated by the arrows. A read major path 14 is used to move bubble domains taken from the storage registers 12 to a bubble domain sensor (not shown).

Bubble domain propagation along the read and write major paths and along the minor loop storage registers occurs when the magnetic field H reorients in the plane of the propagation elements used for the major propagation paths 10, 14 and the storage registers 12.

If the order of data received from the generator is A B C ..., it is desirable to provide this same order of data when the data moves to the sensor along read propagation path 14. If this is not done, an electronic circuit must be provided to unscramble the data, which is disadvantageous. Accordingly, in fig. 1 the direction of propagation in the write major path 10 is the same as that in the read major path 14. This means that the order of data A B C ... is the same in both the read and write major paths.

When storage systems in accordance with fig. 1 are provided using gapped propagation elements such as T-bars, C-bars, half disks, and chevrons, it is straightforward to provide the same propagation direction in the write and read major paths, for a constant sense of rotation of the field H. All that is required is that the spatial orientation of the propagation elements be reversed in the read and write major paths, since bubble domains can easily be moved across the propagation pattern.

However, when contiguous propagation elements, such as contiguous disk propagation elements, are used in the write and read major paths, it is not possible to transfer the bubble domains to the proper edge of the propagation pattern to insure that no data reversal will result. Figs. 2A and 2B illustrate two major/minor loop bubble memories using contiguous propagation elements, where the data reversal problem is either not solved (fig. 2B) or is solved in a way which leads to very marginal operability (fig. 2A).

In more detail, fig. 2A shows a portion of a bubble domain major/minor loop memory organization using contiguous propagation elements. In this figure, a substrate 16 is comprised of a magnetic bubble domain film in which bubble domains can be propagated and a magnetic drive layer having magnetization in the plane of the drive layer. The drive layer can be either an ion implanted portion of a magnetic material, such as a magnetic garnet material, or a magnetically permeable layer having apertures therein. Regions 18 of the magnetic drive layer are portions of that layer which is ion implanted or are comprised of a magnetically permeable layer having magnetization in the plane of the layer. As is well known in the art, portions of the drive layer which are not ion implanted will not have in-plane magnetization. If a continuous magnetically permeable layer is used as the drive layer, then apertures or recesses are created in this continuous layer to provide the edges of the propagation elements.

In fig. 2A, unstippled portions 20 and 22 are non ion-implanted regions of an ion implanted magnetic drive layer, or are apertures in a continuous magnetically permeable layer used as the drive layer. As is well known, bubble domains will travel under the ion implanted region and along its edge, or under a magnetically permeable layer and along its edge, in response to the reorientation of a magnetic field H in the plane of the magnetic drive layer. Thus, bubble domains will travel in the direction of arrow 24 along the lower edge 25 of region 20 and will travel in the direction of arrow 26 along the lower edge 27 of region 22, as field H reorients as shown in fig. 2A.

Movement of magnetic bubble domains along the edge of the magnetic drive layer having in-plane magnetization occurs due to the magnetic charged walls established in the in-plane layer, as pointed out by G.S. Almasi et al in a paper entitled "Bubble Domain Propagation Mechanism in Ion Implanted Structures", presented at the 20th Annual Conference on Magnetism and Magnetic Materials, December 1974, at San Francisco, California. That paper has been published in the Proceedings of that conference. Reference is also made to U.S. patent 4.070.658 for further information relative to charged wall propagation of magnetic bubble domains using an ion implanted drive layer which is separate from the magnetic bubble domain layer.

In the structure of fig. 2A, the order of data provided along a write major path moving bubbles along edge 25 in the direction of arrow 24 is A B C ... . These bubble domains are transferred into the minor loop storage registers 28 and propagate half-way around these registers to positions where they can be removed from registers 28. After transfer to the read major path which moves bubbles along edge 27 in the direction of arrow 26, it is readily apparent that the same data order A B C ... is maintained. Therefore, there is no data reversal using this structure. However, this solution is not a good one, since bubble domains removed from the storage registers 28 must propagate across a non ion-implanted region 22 before getting to propagation edge 27 along the border of the ion-implanted drive layer. In the case of a magnetically permeable layer being used as the magnetic drive layer, the bubble domains would have to move from registers 28 across a region of the bubble domain film which has no in-plane magnetic drive layer thereover, before arriving at propagation edge 27 of the magnetic drive layer. Since a bubble domain would prefer to remain under a magnetic layer having in-plane magnetization, the structure of fig. 2A does not provide a good solution to the data reversal problem. Copending U.S. application 839.720, filed October 5, 1977 shows a transfer switch in which bubble domains are moved beneath a non-implanted region of the drive layer, by a combination of conductor field and featured permalloy. Thus, without additional structure, movement of bubbles away from an in-plane magnetization region is very difficult.

The structure of fig. 2B is one in which bubble domains do not have to be moved to portions of the bubble film where they will not be magnetically coupled to a magnetic charged wall in an adjacent drive layer. Since portions of the apparatus used in fig. 2B are similar to those in fig. 2A, most of the same reference numerals will be used. Thus, substrate 16 is comprised of a layer in which the magnetic bubble domains exist and can be moved, as well as a magnetic drive layer having in-plane magnetization. The portions of the drive layer having in-plane magnetization are indicated by the stippled regions 18, while regions 20 and 22 are portions of the drive layer which do not have in-plane magnetization. In the case of an ion implanted drive layer, regions 20 and 22 are not ion implanted. In the case of a magnetically permeable drive layer, regions 20 and 22 are apertures therein.

Bubble domains propagate to the left in the direction of arrow 24 along the lower edge 25 of region 20, and propagate to the right in the direction of arrow 26 along the upper edge 29 of region 22, as field H reorients. Data propagates in the write major path along edge 25 in the direction of arrow 24 with a data sequence A B C ... . This data is transferred to the minor loop storage registers 28 and propagates half way around these registers before transfer to the read major path which moves the data along edge 29 in the direction of arrow 26. As is apparent, the data order is reversed in the read major path and becomes ... C B A ... .

Thus, while bubble domains are never moved under regions of the drive layer which do not have in-plane magnetization in this structure, the problem of data reversal is not solved.

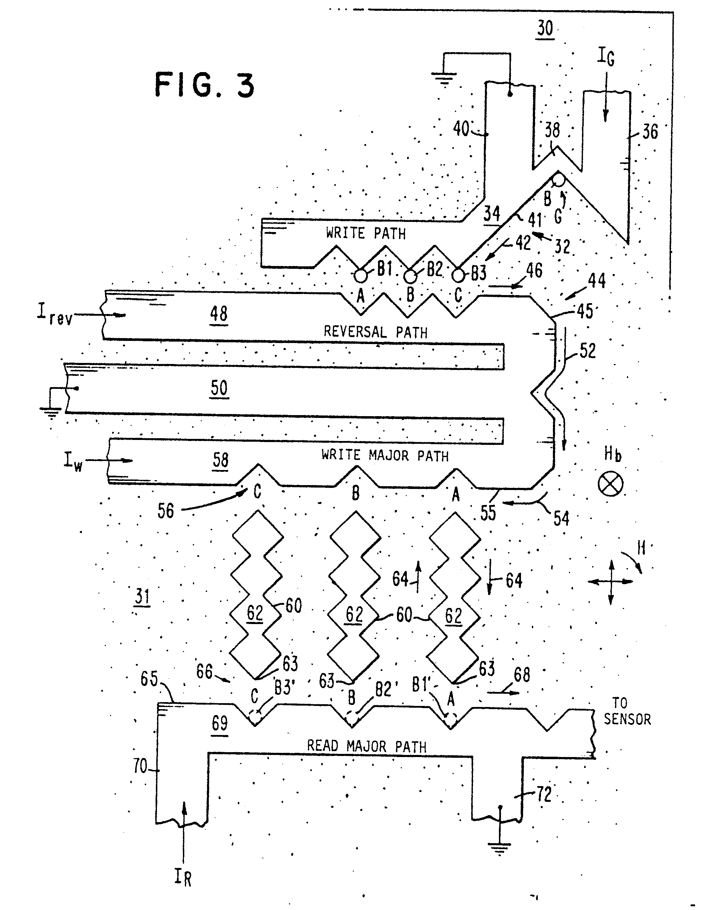

The structure of fig. 3 solves the problem of data reversal in a way in which other problems are not introduced. For example, bubble domains in the structure of fig. 3 never have to be transferred into regions of the bubble domain film where they cannot couple to a magnetic drive layer having in-plane magnetization.

In more detail, a substrate 30 includes the magnetic film in which the bubble domains exist and a magnetic drive layer having in-plane magnetization. Regions of the drive layer having in-plane magnetization are shown as stippled regions 31 in this drawing. Regions which are unstippled correspond to portions of the drive layer which do not exhibit in-plane magnetization. For example, in the case of an ion implanted drive layer, the stippled portions are ion implanted while the unstippled portions are not ion implanted. In the case of a magnetic overlay comprising a magnetically permeable layer, portions of the layer having in-plane magnetization are shown as stippled regions, while unstippled regions are those in which apertures are created in the magnetically permeable layer.

It has been found that the electrically conductive material (such as gold) used for an ion implantation mask or for a deposition mask can also function to carry current in a magnetic bubble domain memory. Thus, the various current carrying conductors shown in fig. 3 are portions of the mask used to ion implant the magnetic drive layer.

The storage system of fig. 3 includes a write path 32 having a bubble domain generator G associated therewith. Write path 32 includes an electrically conductive masking material 34, such as gold, a portion of which is used to carry the generator current $I_G$. This current flows through portion 36, through the inverted V-portion 38, and then to ground through portion 40. The magnetic field created by current $I_G$ is used to nucleate a bubble domain B in the region of the bubble film below the stippled portion of the drive layer. The domains B produced by generator G move along lower edge 41 of the write path in the direction of arrow 42 as field H reorients in the plane of the stippled drive layer. The order of this data is A B C, and three bubble domains B1, B2, and B3 are shown in the lower portion of write loop 32.

The next portion of the storage system is comprised of a reversal switch 44, having an edge 45 of the drive layer along which magnetic bubble domains propagate in the direction of arrow 46 as field H reorients. Portions of the mask used to produce the propagation elements (edge 45) along which bubble domains travel in the reversal switch 44 are also used to carry electrical current. Thus, a current $I_{rev}$ flows through conductor portion 48 and then to ground through conductor portion 50. Bubble domains B1, B2, and B3 can be transferred to edge 45 by sending current $I_{rev}$ through portions 48 and 50 of the conductor layer. When bubbles B1-B3 are transferred to edge 45 of the in-plane stippled region, they travel along this edge in the direction of arrows 46 and 52. As field H continues to reorient, domains B1-B3 follow a path indicated by arrow 54 until they reach the edge 55 of the write major path 56. Another portion 58 of the gold overlay is used to provide a current carrying path for the write current $I_W$. This current flows through conductor portion 58 and then back to ground through conductor portion 50.

When the bubble domains B1-B3 arrive in the write major path 56, it is apparent that their order has been reversed and is now C B A. These data items can be transferred to the minor loop shift registers 60, which are in-plane regions of the magnetic drive layer surrounding the non-magnetic, electrically conductive material 62. As field H reorients, bubble domains will propagate around the registers 60, in the direction of arrows 64.

After the data items represented by bubbles B1-B3 are transferred into the minor loops 60, they propagate half-way around these loops to positions 63 opposite the cusps along the edge 65 of the read major path 66. They are then in a position to be transferred to the read major path for propagation along edge 65 in the direction of arrow 68 to a bubble domain sensor (not shown). Dashed circles B1', B2', and B3' represent the positions of bubble domains B1, B2, B3, respectively, at a later time when these domains are transferred to edge 65 of read major path 66.

Edge 65 of the read major path 66 is formed using portion 69 of the electrically conductive mask. To transfer bubbles from access positions 63 to edge 65, a read current $I_R$ flows through conductor portions 70 and 69, then to ground through position 72. As is apparent, these bubble domains now have the data order A B C, which is the data order initially provided in write path 32. Thus, the structure of fig. 3 eliminates the data reversal problem. Furthermore, bubble domains are never forced beneath a portion of the magnetic drive layer which does not have in-plane magnetization. Therefore, all bubble propagation and transfer functions are magnetically possible using minimum amplitudes of magnetic drive field H and currents $I_{rev}$, $I_W$, and $I_R$.

Transfer switches for transferring bubble domains from one propagation register to another are known in the prior art. A particularly suitable switch is described in copending U.S. application 755.897, filed December 30, 1976. The transfer switch of that copending application uses magnetic charged walls to move magnetic bubble domains from one register to another upon the incidence of a current pulse. Charged wall transfer switches can be used to move magnetic bubble domains from write path 32 to reversal path 44, from write major path 56 to minor loops 60, and from minor loops 60 to the read major path 66. As will be noted from the drawing, the transfer conductors are portions of the mask used to define the stippled regions of the magnetic drive layer having in-plane magnetization, and therefore are self-aligned with the propagation registers, which is the feature taught by aforementioned copending U.S. application 839.720.

Data reversal switch 44 could be provided between the minor loops 60 and the read major path 66, rather than between the write path 32 and the write major path 56. That is, the data reversal switch can be used for read-out instead of write-in. However, because there is some time consumed as the bubbles propagate around the reversal switch 44, it is expected that most bubble storage systems will be designed to use the reversal switch 44 for writing rather than for reading. If this is done, there will be no loss of performance in either access time or data rate.

This data reversal switch includes a transfer switch for parallel transfer of sequential data from one register (such as write path 32) to another register (such as reversal path 45) which moves the data in the opposite direction with the reverse sequence. In order to reverse the order of the data, both parallel transfer and propagation in the opposite direction are required. Data order cannot be reversed merely by propagating a data stream around a contiguous element propagation path prior to transfer to the storage loops.

In the practice of this invention, storage organizations other than the familiar major/minor loop organization can be used. The important point is that an on-chip reversal switch is provided to change the order of the data on the magnetic chip in order to insure that the output data to the sensor has the same order as the input data. Such a problem would usually be expected to exist in memory organizations using separate write-in propagation paths and read-out propagation paths.

It will also be apparent to one of skill in the art that propagation patterns other than those comprising the illustrated contiguous propagation elements could incorporate the teachings of this invention. In its broadest sense, the present invention provides an on-chip solution to the problem of data reversal in a magnetic bubble domain storage system using contiguous propagation elements across which bubble domains cannot easily move. Use of this reversal switch eliminates data reversal without requiring a change in the sense of reorientation of the magnetic drive field, or a change in its magnitude. Also, the same type of propagation elements can be used in the entire magnetic chip. Thus, those of skill in the art will appreciate that order storage systems and other propagation elements than those shown herein can be used to implement the present invention.

CLAIMS

1. Magnetic bubble domain storage chip comprised of patterns of contiguous magnetic propagation elements having in-plane magnetization, along which patterns move bubble domains in response to the continuous reorientation of a magnetic field through a plurality of cycles, said magnetic field reorienting in the same sense in each of said cycles, said patterns forming a first shift register for serially moving a first data sequence pattern of magnetic bubble domains, a plurality of storage registers for storing said bubble domains received from said first shift register, and a second shift register for serially moving bubble domains in a data pattern received from said storage registers, characterized in that said magnetic bubble domain storage chip further comprises reversal means (44) located on said magnetic chip between said first shift register (32) and said storage registers (60) for receiving said data pattern of bubble domains and for changing said first data sequence (A, B, C) to a second data sequence (C, B, A), which is the reverse of said first data sequence, said reversal means including a bubble domain propagation path (45) along which bubble domains in said data pattern move in response to the reorientation of said magnetic field (H), first transfer means (48) for parallel transfer of said domains from said first shift register to said propagation path, and second transfer means (58) for parallel transfer of said domains from said reversal means to said storage registers.

2. Magnetic bubble domain storage chip according to claim 1, characterized in that the bubble propagation path (45) of said reversal means likewise comprises contiguous magnetic propagation elements.

3. Magnetic bubble domain storage chip according to claim 2, characterized in that said contiguous propagation elements are comprised of edges of ion implanted regions of a magnetic layer.

4. Magnetic bubble domain storage chip according to claim 2, characterized in that said contiguous propagation elements are comprised of edges of apertures in a continuous, magnetically permeable layer.

5. Magnetic bubble domain storage chip according to claim 3 or 4, characterized in that said first and second transfer means (48, 58) are comprised of a center tapped electrical conductor overlying said bubble domain propagation path (45) of said reversal means (44).

10
A
B
C
FROM GENERATOR
12
12
H
TO SENSOR
A
B
C
14
16
20
A
B
C
24
25
28
28
H
18
22
A
B
C
26
27
16
20
A
B
C
24
25
28
28
H
18
A
B
C
29
22
26

FIG. 1

FIG. 2A

FIG. 2B

FIG. 3

30
$I_G$
40
38
36
B
G
34
41
WRITE PATH
42
32
B1
B2
B3
46
44
A
B
C
45
$I_{rev}$
48
REVERSAL PATH
52
50
$I_W$
58
WRITE MAJOR PATH
$H_b$
C
B
A
56
55
54
H
64
64
31
62
60
62
60
62
63
63
63
66
68
65
C
B3'
B
B2'
B1'
A
TO SENSOR
69
READ MAJOR PATH
70
72
$I_R$